# EUROPEAN PATENT SPECIFICATION

(11) **EP 1 770 186 B1**
(45) Date of publication and mention of the grant of the patent: **28.04.2010**
(21) Application number: 06255048.8
(22) Date of filing: 29.09.2006
(51) Int. Cl.: C23C 14/24, C23C 14/20

(54) **Evaporation source and vacuum deposition apparatus using the same**
Verdampfungsquelle und Vakuumabscheidungsvorrichtung mit der Vakuumvrdampfungsquelle
Source d'évaporation et appareil de dépôt sous vide en utilisant

(30) Priority: 30.09.2005 KR 20050092264
(43) Date of publication of application: 04.04.2007
(73) Proprietor: Samsung Mobile Display Co., Ltd., Suwon-si Gyeonggi-do (KR)
(72) Inventor: Lee, Jeong-Yeol, Samsung SDI Co., Ltd., Yongin-si Gyeonggi-do (KR); Choi, Yong-Joong, Samsung SDI Co., Ltd., Suwon-si Gyeonggi-do (KR); Ma, Sung Rag, Samsung SDI Co., Ltd., Suwon-si Gyeonggi-do (KR); Min, Kyoung-Wook, Samsung SDI Co., Ltd., Suwon-si Gyeonggi-do (KR)
(74) Representative: Mounteney, Simon James

(56) References cited:
- EP-A1- 1 318 207
- JP-A- 5 139 882
- JP-A- 8 092 734
- US-A1- 2004 035 366

## Description

### BACKGROUND OF THE INVENTION

### 1. Field of the Invention

The present invention relates to vacuum deposition equipment employed in electroluminescent display devices. In particular, the present invention relates an evaporation source machine and a vacuum deposition apparatus using the same capable of minimizing splashing and substantially reducing deposition of metal oxide particles onto a substrate.

### 2. Description of the Related Art

In general, an electroluminescent (EL) display device is a flat display device where voltage may be employed in light emitting layers to combine electrons and holes to form images. EL display devices have superior characteristics as compared to other display devices, such as excellent visibility, light weight, wide viewing angle, high color purity, and relatively low power consumption.

An EL display device may include a substrate, a light emitting diode having two electrodes, i.e., an anode and a cathode, and at least one light-emitting layer therebetween. Accordingly, holes supplied from the anode and electrons supplied from the cathode may combine in the light-emitting layer to form excitons, i.e., hole-electron pairs, to emit light while transitioning from an excited state to a ground state.

The light emitting layer and the cathode may generally be formed by a vacuum deposition method. A vacuum deposition apparatus may include a vacuum chamber having an inner pressure of 0.1-0.01 MPa (about 10⁻⁶ to about 10⁻⁷ torr) and an evaporation source that includes a heater and a crucible for accommodating a thin film material therein. In particular, the thin film material may be evaporated from the crucible, applied to a substrate, and solidified by adsorption, deposition, re-evaporation, and so forth. However, in conventional application of evaporated thin film material to a substrate, splashing may often occur, thereby generating non-uniform films, i.e., thin films having dark stains thereon.

Additionally, when the thin film material is a metal material, e.g., magnesium, its upper layer may undergo an oxidation reaction to from a metal oxide layer on an upper surface of the metal material. Subsequently, the metal oxide material may be discharged onto a substrate along with the evaporated metal material. However, since the evaporation temperature of the metal oxide may be substantially higher than the evaporation temperature of the metal, e.g., magnesium oxide may be evaporated at a temperature of about 2500 °C , while magnesium may be evaporated at a temperature of about 500 °C, metal oxide particles may be deposited onto a substrate in a solid state, thereby increasing the resistance of the cathode and generating a short circuit between the anode and the cathode due to metal oxide particles clustering, i.e., forming additional dark spots.

Accordingly, there remains a need to improve the structure of the vacuum deposition apparatus to provide minimized splashing of evaporated material and reduced deposition of metal oxide particles onto a substrate.
EP1 318 207 discloses a raw material chamber that comprises a cylindrical raw material vessel and a heater. The raw material is based in the material vessel and heated by the heater. A partition member is provided in order to help the vent and react to fine material generated by splashing from the raw material vessel from getting in to a deposition chamber in communication with the material vessel.
JP 05139882 discloses a crucible that is provided with one or more covers that have holes in that enable deposition material to pass through.

### SUMMARY OF THE INVENTION

The present invention is therefore directed to an evaporation source machine and a vacuum deposition apparatus using the same, which substantially overcome one or more of the disadvantages of the related art.

It is an object of the present invention to provide an evaporation source machine that is capable of minimizing splashing of evaporated material upon application thereof to a substrate.

It is also an object of the present invention to provide an evaporation source machine that is capable of filtering metal oxide particles and minimizing application thereof to a substrate, and a cover having an outlet.

It is yet another object of the present invention to provide a vacuum deposition apparatus having an evaporation source machine that is capable of providing improved thin film application to a substrate.

Accordingly, a first aspect of the invention provides an evaporation source machine, including a crucible, a heater, and a multi-layered Inner plate positioned inside the crucible, each layer of the multi-layered inner plate having at least one aperture.

Preferably, the multi-layered inner plate may include from two to five layers, Further, a minimum distance between any two adjacent layers of the multi-layered inner plate may be about 2.0 mm and a maximum distance between any two adjacent layers of the multi-layered inner plate may be about 10.0 mm.

The at least one aperture of each layer may have a unique position. Alternatively, the at least one aperture of each layer may have a unique size.

The multi-layered inner plate may have an outer perimeter that is equal to an inner perimeter of the crucible. Additionally, the multi-layered inner plate may be formed of copper, gold, or silver.

The evaporation source machine of the present invention may be formed of graphite, pyrolytic boron nitride (PBN), or metal.

In another aspect of the present invention, there is provided a vacuum deposition apparatus, including a vacuum chamber, a crucible positioned at a lower part of the vacuum chamber, a heater surrounding the crucible, and a multi-layered inner plate positioned inside the crucible, each layer of the multi-layered inner plate having at least one aperture.

A minimum distance between any two adjacent layers of the multi-layered inner plate is about 2.0 mm and a maximum distance between any two adjacent layers of the multi-layered inner plate is about 10.0 mm.. Additionally, the multi-layered inner plate may have an outer perimeter that is equal to an inner perimeter of the crucible.

The at least one aperture of each layer of the multi-layered inner plate may have a unique position. Alternatively, the at least one aperture of each layer of the multi-layered inner plate may have a unique size.

The crucible includes a cover having an outlet. Additionally, the crucible may be formed of graphite, pyrolytic boron nitride (PBN), or metal. The multi-layered inner plate may be formed of copper, gold, or silver.

### BRIEF DESCRIPTION OF THE DRAWINGS

The above and other features and advantages of the present invention will become more apparent to those of ordinary skill in the art upon making reference to the following description in which embodiments thereof will be described with reference to the attached drawings, in which:

FIG. 1 illustrates a perspective view of a vacuum deposition apparatus according to an embodiment of the present invention;

FIG. 2 illustrates an exploded perspective view of an evaporation source machine of the vacuum deposition apparatus illustrated in FIG. 1;

FIG. 3A illustrates a cross-sectional view of the evaporation source machine of the vacuum deposition apparatus illustrated in FIG. 1; and

FIG. 3B illustrates a plan view of layers of the multi-layered inner plate illustrated in FIGS. 2-3A.

### DETAILED DESCRIPTION OF THE INVENTION

The present invention will now be described more fully hereinafter with reference to the accompanying drawings, in which exemplary embodiments of the invention are shown. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the drawing figures, the dimensions of elements and regions may be exaggerated for clarity of illustration. It will also be understood that when an element is referred to as being "on" another element or substrate, it can be directly on the other element or substrate, or intervening elements may also be present. Further, it will be understood that when an element is referred to as being "under" another element, it can be directly under, or one or more intervening elements may also be present. In addition, it will also be understood that when an element is referred to as being "between" two elements, it can be the only element between the two elements, or one or more intervening elements may also be present. Like reference numerals refer to like elements throughout.

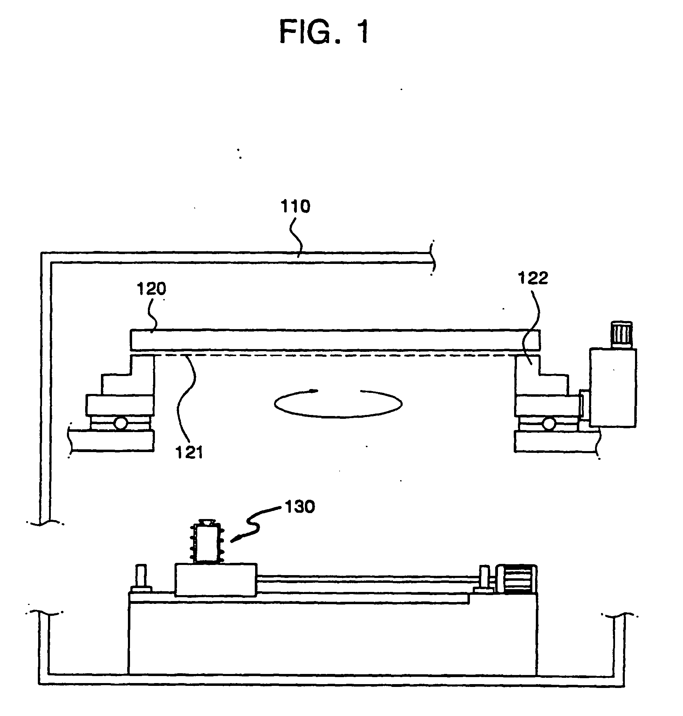

An exemplary embodiment of a vacuum deposition apparatus having an evaporation source machine according to the present invention is more fully described below with reference to FIGS. 1-3B.

As illustrated in FIG. 1, a vacuum deposition apparatus may include a vacuum chamber 110 and an evaporation source machine 130.

The vacuum chamber 110 of the vacuum deposition apparatus may be any suitable pressure-controlled vessel as determined by one of ordinary skill in the art, and it may be connected to a vacuum exhaust system (not shown) to maintain the interior of the vacuum chamber 110 at a vacuum state. The vacuum chamber 110 may also include a supporting frame (not shown) positioned in an upper portion thereof to support a substrate, and a sensor (not shown) attached to an inner wall of the vacuum chamber 110 to measure a thickness of a film layer formed on the substrate treated therein.

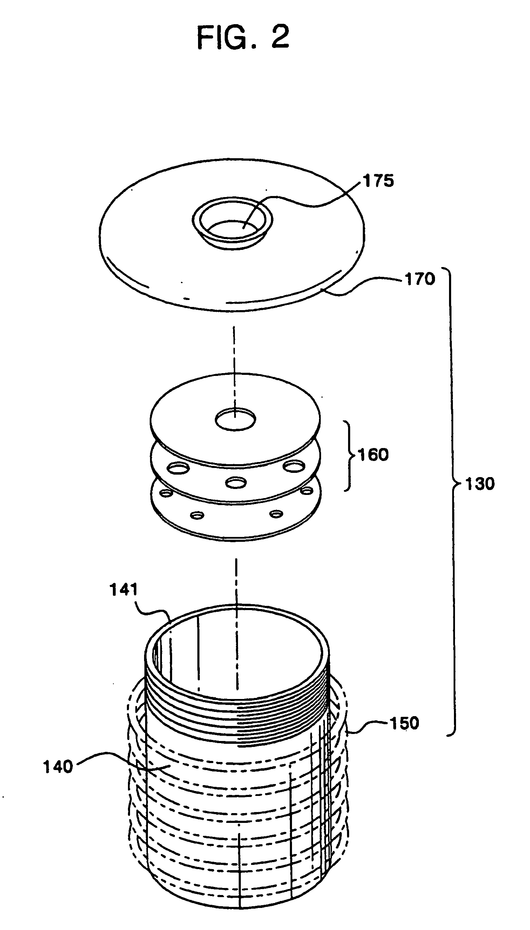

The evaporation source machine 130 of the vacuum deposition apparatus may provide an evaporated material to be coated onto a substrate. Accordingly, the evaporation source machine 130 may be positioned in a lower portion of the vacuum chamber 110, as illustrated in FIG. 1, and it may include a crucible 140, a heater 150, a multi-layered inner plate 160, and a shutter (not shown) for controlling the release of the evaporated thin film material, as illustrated in FIG. 2. Further, the evaporation source machine 130 may be positioned such that its opening, i.e., an outlet for discharging evaporated material, may face a substrate to be treated in the vacuum deposition apparatus.

The crucible 140 of the evaporation source machine 130 may be any suitable heating vessel of any shape, e.g., a cylinder, having sufficient volume to contain a thin film material. Further, the crucible 140 may be formed of a material having high thermal conductivity, such as graphite, pyrolytic boron nitride (PBN), metal, or like materials.

The crucible 140 includes an opening 141 and a cover 170 with an outlet 175, as further illustrated in FIG. 2. The opening 141 may be formed in any convenient shape in an upper portion of the crucible 140 to facilitate discharge of evaporated material from the crucible 140. For example, the opening 141 may be in an upper face, i.e., an upper panel positioned parallel to the base, of the crucible 140, as illustrated in FIG. 2. The cover 170 may be formed in a same shape as the opening 141 to facilitate proper sealing of the crucible 140. The outlet 175 may be formed through the cover 170 in any form and at any location to facilitate discharge of evaporated material from the crucible 140. In particular, the cover 170 may be formed such that evaporated material may be discharged from the crucible 140 only through the outlet 175. Without intending to be bound by theory, it is believed that sealing the crucible 140 with a cover 170 having an outlet 175 is advantageous because the outlet 175 may provide control of the flow of the discharged evaporated material and, thereby, enhance the thickness uniformity of the thin film formed on a substrate.

The heater 150 of the evaporation source machine 130 may be formed by any way known in the art to surround an outer surface of the crucible 140 and to provide sufficient heat to evaporate the material placed therein. For example, the heater 150 may be formed as a coil capable of electrically heating the crucible 140, as illustrated in FIG. 2.

The multi-layered inner plate 160 of the evaporation source machine 130 may be made of any material having high conductivity, e.g., copper, gold, silver, and so forth, and it may be formed in a shape having an outer perimeter that may be equal to an inner perimeter of the crucible 140. In other words, the multi-layered inner plate 160 may be formed to facilitate positioning thereof inside the crucible 140 in sufficient proximity to the inner walls of the crucible 140 to substantially prevent fluid flow between the multi-layered inner plate 160 and the inner walls of the crucible 140.

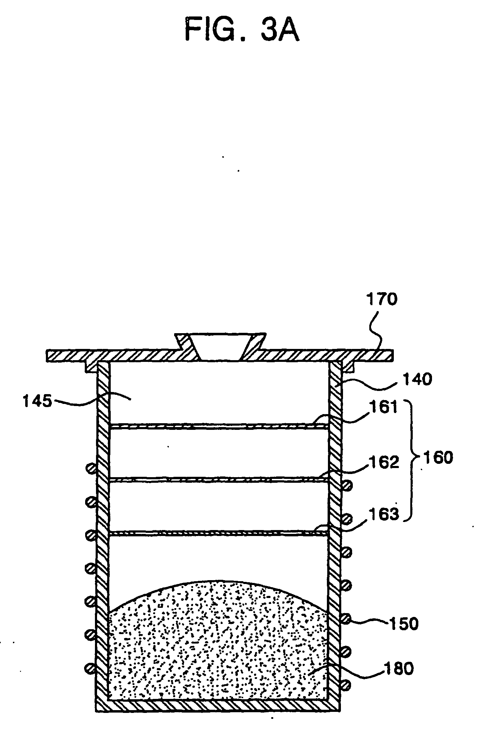

The multi-layered inner plate 160 may include at least two layers positioned in an overlapping configuration, wherein each layer may be formed as a thin plate having at least one aperture therein. Preferably, the multi-layered inner plate 160 may include two to five plate layers. For example, the multi-layered inner plate 160 may have a three-layered plate structure, i.e., first layer 161, second layer 162, and third layer 163 positioned above each other, as illustrated in FIG. 3A. As such, the multi-layered inner plate 160 may be positioned above the evaporated material inside crucible 140, such that the evaporated material may be discharged through the at least one aperture formed in each layer of the multi-layered inner plate 160. In this respect, it should be noted that the configuration of the multi-layered inner plate structure described above does not exclude other structures from the scope of the present invention. For example, the layers may be partially overlapping. Alternatively, the layers may be positioned in a parallel or non-parallel configuration, and so forth.

As further illustrated in FIG. 3A, the crucible 140 may be constructed to contain a thin film material 180 placed at its bottom, such that a space 145 may be formed above the thin film material 180. The multi-layered inner plate 160 may be positioned in the space 145 inside the crucible 140. Without intending to be bound by theory, it is believed that upon evaporation of the thin film material 180, positioning of the multi-layered inner plate 160 in the space 145 may increase an inner pressure applied to the evaporated thin film material 180. Increase of the inner pressure and controlled discharge of the evaporated thin film material 180 through specific apertures in the multi-layered inner plate 160 may minimize splashing of the evaporated thin film material 180 onto a substrate, thereby providing uniform film deposition. Additionally, the increase of the inner pressure and controlled discharge of the evaporated thin film material 180 through specific apertures may substantially prevent deposition of metal oxide onto a substrate due to filtering metal oxide particles through the apertures formed in the multi-layered inner plate 160, as will be discussed in more detail below.

When the multi-layered inner plate 160 has a single-layer structure, the inner pressure below the multi-layered inner plate 160 may be too low to control the flow of the evaporated thin film material 180 and minimize its splashing. Alternatively, when the multi-layered inner plate 160 has a structure having more than 5 layers, the inner pressure may be too high.

The first layer 161, the second layer 162, and the third layer 163 of the multi-layered inner plate 160 may be positioned inside the crucible 140 to have a minimum distance between any two adjacent layers of about 2.0 mm and a maximum distance between any two adjacent layers of about 10.0 mm. When the distances between the first, second, and third layers 161, 162 and 163, respectively, are smaller than 2.0 mm, the inner pressure therebetween may be too high and cause deformation of the multi-layered inner plate 160. Alternatively, when the distances are larger than 10.0 mm, the inner pressure may be too low, thereby facilitating oxidation reaction of the evaporated thin film material 180 and its re-crystallizing on the multi-layered inner plate 160.

As described previously with respect to the structure of the multi-layered inner plate 160, its outer perimeter may be equal to an inner perimeter of the crucible 140. This structure may provide sufficient inner pressure in the space 145 of the crucible 140. It should also be noted that such a close fit between the multi-layered inner plate 160 and the inner wall of the crucible 140 may facilitate heat transfer from the crucible 140 to the multi-layered inner plate 160 and equate the temperature therebetween and, thereby, minimize splashing of the thin film material 180. The heat transfer between the crucible 140 and the multi-layered inner plate 160 may also provide for uniform temperature of the evaporated thin film material 180 throughout the entire crucible 140, i.e., space 145 and multi-layered inner plate 160, thereby minimizing re-crystallization thereof on the multi-layered inner plate 160.

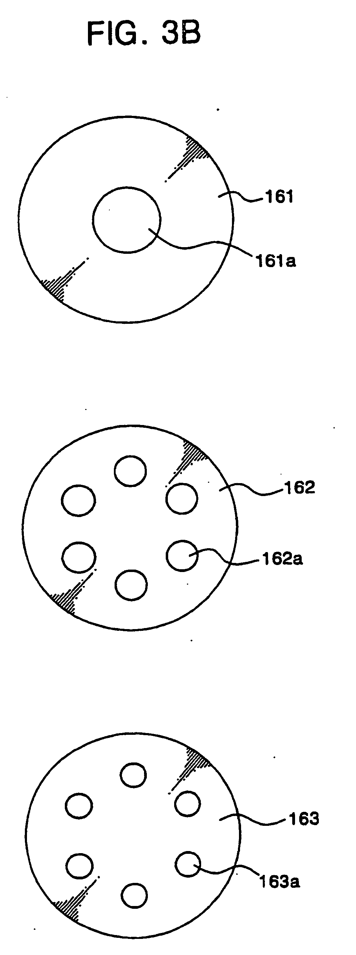

As described previously with respect to the structure of the multi-layered inner plate 160, each layer thereof may include at least one aperture. For example, the first layer 161, the second layer 162, and the third layer 163 of the multi-layered inner plate 160 may have at least one aperture 161 a, 162a and 163a, respectively, formed therein, as illustrated in FIG. 3B. However, it should be noted that the apertures 161a, 162a and 163a should not be aligned with each other. In other words, each aperture 161 a, 162a and 163a may be formed to have a unique size or a unique position. In this respect, it is noted that a "unique size" or a "unique position" may refer to a specific geometric size of an aperture or a specific geometric location of an aperture in a layer. In other words, each layer may have an arrangement of apertures, i.e., at least one aperture, that is geometrically distinguishable in size or position from other layers, such that neither of the apertures may be aligned when the layers are assembled on top of each to form the multi-layered inner plate 160.

For example, as illustrated in FIG. 3B, the apertures 161a, 162a and 163a may be formed at different geometric locations in the layers 161, 162 and 163, respectively. As such, upon assembly of the layers 161, 162 and 163 into a multi-layered inner plate 160, apertures 161a, 162a and 163a may not align with each other. Similarly, the apertures 161 a, 162a and 163a may be formed to have different sizes in the layers 161, 162 and 163, such that upon assembly into a multi-layered inner plate 160, they may not align with each other. Without intending to be bound by theory, it is believed that such structure of apertures 161a, 162a and 163a may facilitate filtering of oxidized evaporated thin film material.

For example, even if metal oxide particles pass through the aperture 163a of the layer 163, i.e., lower-most layer of the multi-layered inner plate 160, they may not pass through the aperture 162a of the layer 162, i.e., layer positioned above the layer 163, due to lack of aperture alignment. Accordingly, metal oxide particles may be filtered, thereby minimizing deposition of metal oxide onto a substrate, decreasing the resistance of the cathode, and preventing a potential short circuit between an anode and the cathode.

An exemplary method of assembly and operation of the vacuum deposition apparatus of an embodiment of the present invention may be performed as follows.

The thin film material 180 may be placed in the bottom of the crucible 140, and a multi-layered inner plate 160 may be assembled and positioned above it. The crucible 140 may be sealed with the cover 175 and placed in the lower part of the vacuum chamber 110 as the evaporation source machine 130.

A substrate 120 may be disposed at an upper part of the vacuum chamber 110, as illustrated in FIG. 1, such that a surface of the substrate 120 to be treated may face the cover 175 of the evaporation source machine 130. A mask 121 having a pattern to be deposited onto the substrate 120 may be applied to the substrate 120 with a substrate fixing device 122.

Next, the heater 150 may be activated to evaporate the thin film material 180 in the crucible 140. The evaporated thin film material 180 may pass through the apertures of the multi-layered inner plate 160 and through the outlet 175 of the cover 170 out of the crucible 140 into the evaporation chamber 110. The evaporated thin film material discharged out of the crucible 140 may be deposited onto the substrate 120.

As illustrated above, the inventive evaporation source machine and the vacuum deposition apparatus employing the same is advantageous in minimizing deposition of metal oxide onto a substrate, decreasing the resistance of the cathode, and preventing a potential short circuit between an anode and the cathode. Accordingly, an EL display device manufactured with the inventive vacuum deposition apparatus may provide an improved image quality due to film uniformity, i.e., lack of black spots, and increased reliability and yield due to improved cathode operation.

Exemplary embodiments of the present invention have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. An evaporation source machine, comprising:
a crucible (140);
a heater (150);
a multi-layered inner plate (160) positioned inside the crucible (140), each layer of the multi-layered inner plate having at least one aperture (162, 163), and
a cover (170) having an outlet (175).

2. An evaporation source machine as claimed in claim 1, wherein the multi-layered inner plate (160) includes from two to five layers.

3. An evaporation source machine as claimed in claim 1 or 2, wherein a minimum distance between any two adjacent layers of the multi-layered inner plate (160) is about 2.0 mm and a maximum distance between any two adjacent layers of the multi-layered Inner plate (160) is about 10.0 mm.

4. An evaporation source machine as claimed in any preceding claim, wherein the at least one aperture (162, 163) of each layer has a unique position.

5. An evaporation source machine as claimed in any preceding claim, wherein the at least one aperture (162, 163) of each layer has a unique size.

6. An evaporation source machine as claimed in any preceding claim, wherein the multi-layered inner plate (160) has an outer perimeter that is equal to an inner perimeter of the crucible (140).

7. An evaporation source machine as claimed in any preceding claim, wherein the crucible (140) is formed of graphite, pyrolytic boron nitride (PBN), or metal.

8. An evaporation source machine as claimed In any preceding claim, wherein the multi-layered inner plate (160) is formed of copper, gold, or silver.

9. A vacuum deposition apparatus, comprising:
a vacuum chamber (110) and an evaporation source machine (130):
wherein the evaporation source machine (130) is as set out in one of claims 1 to 8.

## Patentansprüche

1. Verdampfungsquellenmasehine, die Folgendes umfasst:
einen Tiegel (140);
eine Heizvorrichtung (150);
eine mehrlagige innere Platte (160), die innerhalb des Tiegels (140) angeordnet ist, wobei jede Lage der mehrlagigen inneren Platte wenigstens eine Öffnung (162, 163) hat, und
eine Abdeckung (170), die einen Auslass (175) hat.

2. Verdainpfungsquellenmaschire nach Anspruch 1, wobei die mehrlagige innere Platte (160) von zwei bis zu fünf Lagen einschließt.

3. Verdampfungsquellenmaschine nach Anspruch 1 oder 2, wobei ein minimaler Abstand zwischen zwei beliebigen benachbarten Lagen der mehrlagigen inneren Platte (160) etwa 2,0 mm beträgt und ein maximaler Abstand zwischen zwei beliebigen benachbarten Lagen der mehrlagigen inneren Platte (160) etwa 10,0 mm beträgt.

4. Verdampfungsquellenmaschine nach einem der vorhergehenden Ansprüche, wobei die wenigstens eine Öffnung (162, 163) jeder Lage eine einzigartige Position hat.

5. Verdampfungsquellenmaschine nach einem der vorhergehenden Ansprüche, wobei die wenigstens eine Öffnung (162, 163)jeder Lage eine einzigartige Größe hat.

6. Verdampfungsquellenmaschine nach einem der vorhergehenden Ansprüche, wobei die mehrlagige innere Platte (160) einen Außenumfang hat, der gleich einem Innenumfang des Tiegels (140) ist.

7. Verdampfungsquellenmaschine nach einem der vorhergehenden Ansprüche, wobei der Tiegel (140) aus Graphit, pyrolytischem Bornitrid (PBN) oder Metall geformt ist.

8. Verdampfungsquellenmaschine nach einem der vorhergehenden Ansprüche, wobei die mehrlagige innere Platte (160) aus Kupfer, Gold oder Silber geformt ist.

9. Vakuumabscheidungsvorrichtung, die Folgendes umfasst:
eine Vakuumkammer (110) und eine Verdamprungsquellenmaschine (130),
wobei die Verdampfungsquellenmaschine (130) nach einem der Ansprüche 1 bis 8 ausgelegt ist.

## Revendications

1. Machine à source d'évaporation, comprenant :
un creuset (140) ;
un dispositif de chauffage (150);
une plaque interne à couches multiples (160) positionnée à l'intérieur du creuset (140), chaque couche de la plaque interne à couches multiples comportant au moins une ouverture (162, 163), et
un couvercle (170), comportant une sortie (175).

2. Machine à source d'évaporation selon la revendication 1, dans laquelle la plaque interne à couches multiples (160) englobe entre deux et cinq couches.

3. Machine à source d'évaporation selon les revendications 1 ou 2, dans laquelle une distance minimale entre deux quelconques couches adjacentes de la plaque interne à couches multiples (160) correspond à environ 2,0 mm et une distance maximale entre deux quelconques couches adjacentes de la plaque interne à couches multiples (160) correspond à environ 10,0 mm.

4. Machine à source d'évaporation selon l'une quelconque des revendications précédentes, dans laquelle la au moins une ouverture (162, 163) de chaque couche a une position unique.

5. Machine à source d'évaporation selon l'une quelconque des revendications précédentes, dans laquelle la au moins une ouverture (162, 163) de chaque couche a une taille unique.

6. Machine à source d'évaporation selon l'une quelconque des revendications précédentes, dans laquelle la plaque interne à couches multiples (160) a un périmètre extérieur égal à un périmètre intérieur du creuset (140).

7. Machine à source d'évaporation selon l'une quelconque des revendications précédentes, dans laquelle le creuset (140) est formé à partir de graphite, de nitrure de bore pyrolytique (PBN) ou de métal,

8. Machine à source d'évaporation selon l'une quelconque des revendications précédentes, dans laquelle la plaque interne à couches multiples (160) est formée à partir de cuivre, d'or ou d'argent.

9. Appareil de dépôt sous vide, comprenant :
une chambre à vide (110) et une machine à source d'évaporation (130) ;
la machine à source d'évaporation (130) étant conforme à l'une des revendications 1 à 8,
